# EUROPEAN PATENT APPLICATION

(11) **EP 2 330 736 A1**
(43) Date of publication of application: **08.06.2011**
(21) Application number: 09806329.0
(22) Date of filing: 30.06.2009
(51) Int. Cl.: H03G 3/20

(54) **PROCESSING METHOD, SYSTEM AND PROCESSING DEVICE FOR GAIN CONTROL**

(30) Priority: 14.08.2008 CN 200810118364
(71) Applicant: Huawei Technologies Co., Ltd., Longgang District, Shenzhen Guangdong 518129 (CN)
(72) Inventor: LIN, Yangbo, Shenzhen Guangdong 518129 (CN)
(74) Representative: Epping - Hermann - Fischer
(86) International application number: PCT/CN2009/072535
(87) International publication number: WO 2010/017726

(57) **Abstract**

A method, a system and a processing device for exercising gain control are disclosed. The method includes: obtaining control information related to automatic gain control; and exercising automatic gain control according to the control information. The processing device includes: an obtaining unit, configured to obtain control information related to automatic gain control; and a processing unit, configured to exercise automatic gain control according to the control information. The system includes a control device and a processing device. In the embodiments of the present invention, the processing device obtains information required for automatic adjustment, and the gain control based on automatic adjustment becomes simpler and more efficient.

## Description

### FIELD OF THE INVENTION

The present invention relates to the field of network technologies, and in particular, to a method, a system and a device for exercising gain control.

### BACKGROUND

A Media Gateway Controller (MGC) and a Media Gateway (MG) are two key components of a packet-based network in an architecture where the service function is separated from the bearing function. The MGC is responsible for service control and the MG is responsible for media bearing. In this way, the service control plane is separated from the media bearing plane, and thus network resources are shared sufficiently, device upgrade and service extension are simplified, and the costs of development and maintenance are slashed.

The (media) gateway control protocol is a main protocol for communication between the MG and the MGC. Currently, two widely used gateway control protocols are the H.248/MeGaCo and the Media Gateway Control Protocol (MGCP). The H.248/MeGaCo evolves from the MGCP. Gain control is one of the basic functions for resource and media control, and can meet requirements of enhancing or weakening signals and/or media in various applications flexibly. Gain control is implemented in two ways: fixed adjustment, namely, enhancing or weakening the signals and/or media according to a preset fixed value; or automatic adjustment, namely, enhancing or weakening the signals and/or media according to a value generated adaptively. Obviously, automatic adjustment is more flexible than fixed adjustment, but is more complicated in terms of the implementation mechanism. Currently, in the architecture where the MGC is separated from the MG, the MGC can instruct the MG to apply fixed adjustment or automatic adjustment to gain control, but no effective mechanism is available through which the MGC can indicate detailed information required for automatic adjustment to the MG.

### SUMMARY

The embodiments of the present invention provide a method, a system and a processing device for exercising gain control. In this way, the processing device can obtain information required for automatic adjustment, and the gain control based on automatic adjustment becomes simpler and more efficient.

An embodiment of the present invention provides a method for exercising gain control. The method includes:
obtaining control information related to automatic gain control; and
exercising automatic gain control according to the control information.

A processing device provided in an embodiment of the present invention includes:
an obtaining unit, configured to obtain control information related to automatic gain control; and
a processing unit, configured to exercise automatic gain control according to the control information.

A system for exercising gain control in an embodiment of the present invention includes:
a control device, configured to send control information related to automatic gain control to a processing device; and
the processing device, configured to receive the control information related to automatic gain control from the control device, and exercise automatic gain control according to the control information.

In the embodiments of the present invention, the processing device obtains the control information related to automatic gain control, which makes gain control based on automatic adjustment simpler and more efficient.

### BRIEF DESCRIPTION OF THE DRAWINGS

FIG. 1 is a flowchart of a method for exercising gain control according to a first embodiment of the present invention;
FIG. 2 is a flowchart of a method for exercising gain control according to a second embodiment of the present invention;
FIG. 3 is a flowchart of a method for exercising gain control according to a third embodiment of the present invention;
FIG. 4 is a flowchart of a method for exercising gain control according to a fourth embodiment of the present invention;
FIG. 5 shows the structure of a processing device according to an embodiment of the present invention; and
FIG. 6 shows the structure of a system for exercising gain control according to an embodiment of the present invention.

### DETAILED DESCRIPTION OF THE EMBODIMENTS

The technical solution under the present invention is described below with reference to the accompanying drawings and exemplary embodiments.

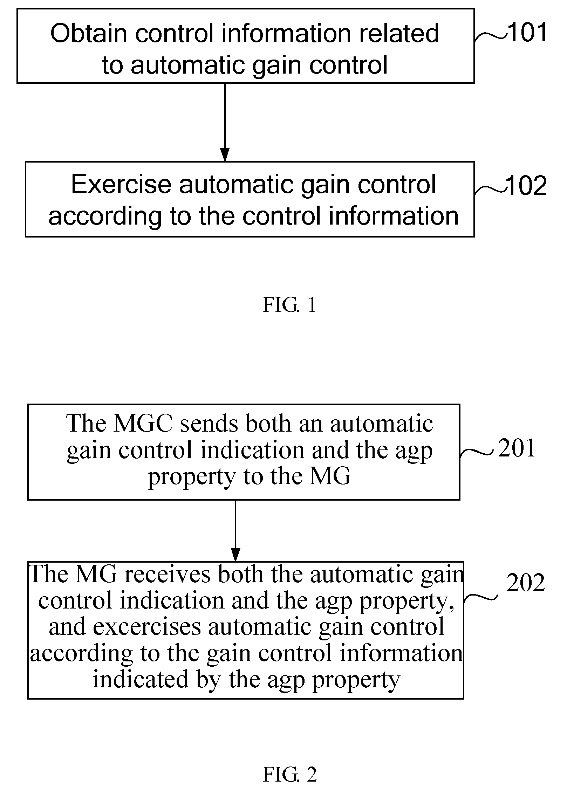

FIG. 1 is a flowchart of a method for exercising gain control according to the first embodiment of the present invention. The method includes the following steps:
Step 101: Obtain control information related to automatic gain control.
Step 102: Exercise automatic gain control according to the control information.

The entity that performs step 101 and step 102 is a processing device.

In this embodiment, the processing device obtains the information required for automatic adjustment, and the gain control based on automatic adjustment becomes simpler and more efficient. Moreover, if the processing device obtains the control information from the control device, the control device can control detailed parameters of the automatic gain control exercised by the processing device.

FIG. 2 is a flowchart of a method for exercising gain control according to the second embodiment of the present invention. This embodiment is applicable to the scenario in which an MGC exercises gain control over an MG. The MGC is a control device, and the MG is a processing device. In this embodiment, the H.248 protocol or the MGCP protocol is extended so that the property parameter of the gateway control protocol or the media gateway control protocol indicates the gain control information. The gain control information includes at least one item of the following parameters: start level, target level, and silence threshold, for example.

Before the steps of this embodiment are implemented, a property is extended in the H.248 protocol or the MGCP protocol to indicate the gain control information. This property indicates the control information related to automatic control. More specifically, the preceding three parameters may be contained in one property. For example, this property is named as an automatic gain parameter (represented by "agp"). This property may be a string, and its value is a list. This list includes three elements respectively corresponding to the three parameters mentioned above.

This embodiment includes the following steps:
Step 201: The MGC sends both an automatic gain control indication and the agp property to the MG. Through the automatic gain control indication, the MGC instructs the MG to exercise automatic gain control.
Step 202: The MG receives both the automatic gain control indication and the agp property, and exercises automatic gain control according to gain control information indicated by the agp property. The automatic gain control is gain control based on automatic adjustment.

Further, if the MGC does not send the automatic gain control indication when sending the property, which makes the MG fail to obtain the automatic gain control indication when obtaining the property, the MG exercises automatic gain control in this way: The MG returns a processing error response to the MGC, for example, an error code and/or a text description indicating required information missing.

In this embodiment, the gain control information is carried in a property sent to the MG, the MG obtains the information required for automatic adjustment, and the gain control based on automatic adjustment becomes simpler and more efficient. Moreover, the MGC may further control detailed parameters of the automatic gain control exercised by the MG.

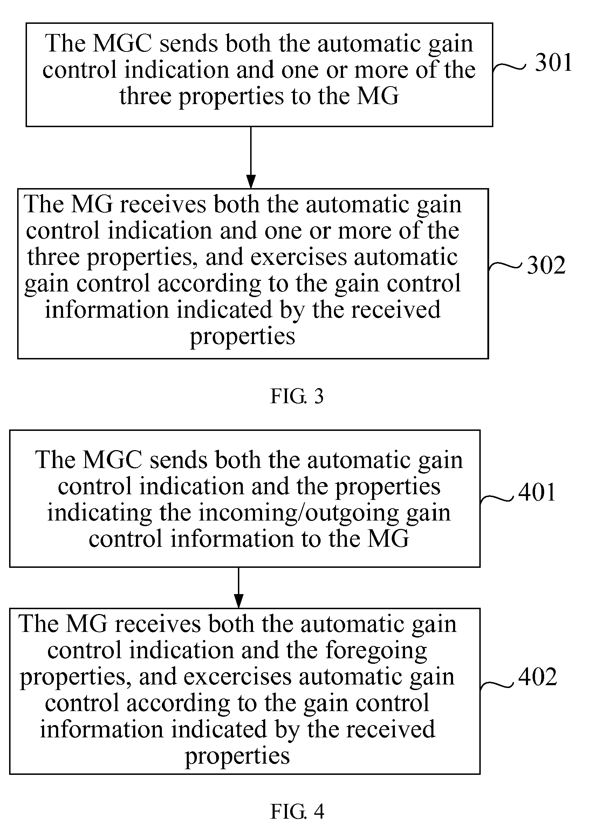

FIG. 3 is a flowchart of a method for exercising gain control according to the third embodiment of the present invention. This embodiment is applicable to the scenario that an MGC exercises gain control over an MG. The MGC is a control device, and the MG is a processing device. In this embodiment, the H.248 protocol or the MGCP protocol is extended so that each property parameter of the gateway control protocol or the media gateway control protocol indicates an item of the gain control information. The gain control information includes at least one item of the following parameters: start level, target level, and silence threshold, for example.

Before the steps of this embodiment are implemented, properties are added in the H.248 protocol or the MGCP protocol to indicate different gain control information. The properties indicate the control information related to automatic control. Specifically, each of the three parameters above corresponds to one property. For example, the three properties are named as start level ("sl"), target level ("tl"), and silence threshold ("st"), respectively. The three property descriptors are integers or strings.

This embodiment includes the following steps:
Step 301: The MGC sends to the MG an automatic gain control indication, and one or more of the three properties (sl, tl, and st). Through the automatic gain control indication, the MGC instructs the MG to exercise automatic gain control.
Step 302: The MG receives both the automatic gain control indication and one or more of the three properties (sl, tl, and st), and exercises automatic gain control according to the gain control information indicated by the received properties. The automatic gain control is gain control based on automatic adjustment.

Further, if the MGC does not send the automatic gain control indication when sending one or more of the three properties (sl, tl, and st), which makes the MG fail to obtain the automatic gain control indication at the time of obtaining the properties, the MG exercises the automatic gain control in this way: The MG returns a processing error response to the MGC, for example, an error code and/or a text description indicating required information missing.

In this embodiment, the gain control information is carried in multiple properties sent to the MG, the MG obtains the information required for automatic adjustment, and the gain control based on automatic adjustment becomes simpler and more efficient. Moreover, the MGC can control detailed parameters of the automatic gain control exercised by the MG.

FIG. 4 is a flowchart of a method for exercising gain control according to the fourth embodiment of the present invention. This embodiment is applicable to the scenario that an MGC exercises gain control over an MG. The MGC is a control device, and the MG is a processing device. In this embodiment, the H.248 protocol or the MGCP protocol is extended so that the property parameters of the gateway control protocol or the media gateway control protocol indicates the gain control information or every item of the gain control information. The gain control information includes at least one item of the following parameters: start level, target level, and silence threshold, for example. Unlike in the second embodiment and the third embodiment, the gain control information in the fourth embodiment includes incoming gain control information and outgoing gain control information. The incoming gain control information is intended for the incoming signals and/or media, and the outgoing gain control information is intended for the outgoing signals and/or media. The incoming refers to receiving signals and/or media at the MG, and the outgoing refers to sending signals and/or media from the MG. The incoming gain control information includes at least one of: incoming start level, incoming target level, and incoming silence threshold; and the outgoing gain control information includes at least one of: outgoing start level, outgoing target level, and outgoing silence threshold.

Before the steps of this embodiment are implemented, one or more properties are used to indicate respectively the incoming gain control information and/or the outgoing gain control information. Such properties indicate control information related to automatic control.

In the case that one property indicates the incoming gain control information and/or the outgoing gain control information, the incoming start level, the incoming target level, and the incoming silence threshold may be included in one property (represented by "iagp"); and the outgoing start level, the outgoing target level, and the outgoing silence threshold may be included in another property (represented by "oagp").

In the case that multiple properties indicate the incoming gain control information and/or the outgoing gain control information, the incoming start level, the incoming target level, and the incoming silence threshold may correspond to three properties which are represented by "isl", "itl", and "ist" respectively; and the outgoing start level, the outgoing target level, and the outgoing silence threshold may correspond to three properties which are represented by "osl", "otl", and "ost" respectively.

This embodiment includes the following steps:
Step 401: The MGC sends an automatic gain control indication and the foregoing property to the MG. Through the automatic gain control indication, the MGC instructs the MG to exercise automatic gain control.
Step 402: The MG receives both the automatic gain control indication and the property, and exercises automatic gain control according to gain control information indicated by the received properties. The automatic gain control is gain control based on automatic adjustment.

Further, if the MGC does not send the automatic gain control indication when sending the property, which makes the MG fail to obtain the automatic gain control indication at the time of obtaining the property, the MG exercises the automatic gain control in this way: The MG returns a processing error response to the MGC, for example, an error code and/or a text description indicating lack of required information missing.

In this embodiment, one or more properties indicate respectively gain control parameters corresponding to the incoming signals and/or media and the outgoing signals and/or media respectively. The gain control information is sent to the MG, so that the MG obtains the information required for automatic adjustment, and the gain control based on automatic adjustment becomes simpler and more efficient; moreover, the MGC can control detailed parameters of the automatic gain control exercised by the MG.

The second embodiment, the third embodiment, and the fourth embodiment above are not only applicable to the gain control exercised by the MGC over the MG, but also applicable to media resource server in a split architecture, namely, to the gain control exercised by the media resource control device over the media resource processing device, or the gain control exercised by the media control function device on the media delivery function device.

In the second embodiment, the third embodiment, and the fourth embodiment above, the control device sends the control information to the processing device. In another embodiment of the present invention, the default value of any parameter in the gain control information can be preset on the processing device. If the control device does not send the gain control information to the processing device, or does not send all control information required for automatic gain control to the processing device (for example, the control device sends only one or two of the following parameters: the start level, the target level, and the silence threshold), the processing device uses the preset default value of the parameter to exercise automatic gain control. That is, the gain control information is sent by the MGC to the MG, or preset on the MG; or, the gain control information is sent by the media resource control device to the media resource processing device, or is preset on the media resource processing device; or, the gain control information is sent by the media control function device to the media delivery function device, or is preset on the media delivery function device.

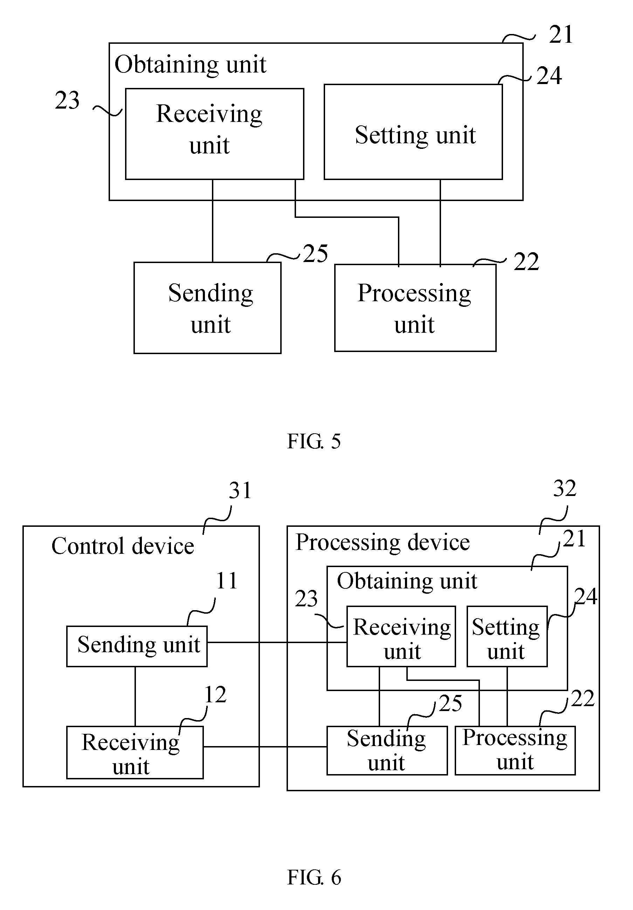

FIG. 5 shows the structure of a processing device according to an embodiment of the present invention. The processing device in this embodiment includes:
an obtaining unit 21, configured to obtain control information related to automatic gain control; and
a processing unit 22, configured to exercise automatic gain control according to the control information.

The control information in this embodiment may include at least one of: start level, target level, and silence threshold. The control information may be specific to the incoming direction and the outgoing direction respectively, or the property of the gateway control protocol or the media gateway control protocol indicates the control information or every item of the control information.

The obtaining unit 21 in this embodiment may include: a receiving unit 23, configured to receive, from the control device, property indicating control information related to automatic gain control.

The obtaining unit 21 in this embodiment may further include: a setting unit 24, configured to preset control information. The processing device can use the default value of each parameter in the control information preset by the setting unit 24 to exercise automatic gain control when the processing device receives no control information sent by the control device.

The processing device in this embodiment may further include: a sending unit 25, configured to send a processing error response if the receiving unit 23 receives no automatic gain control indication when receiving the properties.

Specifically, the receiving unit 23 receives property indicating gain control information sent by the control device, and then the processing unit 22 exercises automatic gain control according to the gain control information. Further, the sending unit 25 sends a processing error response to the control device if the receiving unit 23 receives no automatic gain control indication when receiving the property.

The processing device in this embodiment may be an MG, or a media resource processing device, or a media delivery function device; or may be integrated in the MG, or in the media resource processing device, or in the media delivery function device.

In this embodiment, by obtaining one or more properties indicating the gain control information, the processing device obtains the information required for automatic adjustment, and the gain control based on automatic adjustment becomes simpler and more efficient.

FIG. 6 shows the structure of a system for exercising gain control according to an embodiment of the present invention. The system in this embodiment includes:
a control device 31, configured to send control information related to automatic gain control to a processing device 32; and
a processing device 32, configured to receive, from the control device 31, the control information related to automatic gain control, and exercise automatic gain control according to the control information.

The control device 31 is further configured to receive a processing error response returned by the processing device 32 if the control device 31 sends no automatic gain control indication when sending the control information related to automatic gain control. Specifically, as shown in FIG. 6, the control device 31 in this embodiment includes: a sending unit 11, configured to send the control information related to automatic gain control. The sending unit 11 sends the control information to the processing device 32.

The control information in this embodiment may include at least one of: start level, target level, and silence threshold. The control information may be specific to the incoming direction and the outgoing direction respectively, and the properties of the gateway control protocol or the media gateway control protocol indicates the control information or every item of the control information. One property indicates the gain control information, or different properties indicate different items in the gain control information.

Further, the sending unit 11 sends both the automatic gain control indication and the property. Alternatively, the sending unit 11 sends no automatic gain control indication when sending the properties. In this case, the control device 31 further includes a receiving unit 12, which is configured to receive a processing error response returned by the processing device 32 if the sending unit 11 sends no automatic gain control indication when sending the properties.

The control device 31 in this embodiment may be an MGC, or a media resource control device, or a media control function device; or may be integrated in the MGC, or in the media resource control device, or in the media control function device.

Further, the processing device 32 in this embodiment may be any embodiment of the processing device described above. As shown in FIG. 6, the sending unit 11 is the sending unit in the control device 31, but the sending unit 25 is the sending unit in the processing device 32, so the sending unit 11 and the sending unit 25 are not the same one; the receiving unit 12 is the receiving unit in the control device 31, but the receiving unit 23 is the receiving unit in the processing device 32, so the receiving unit 12 and the receiving unit 23 are not the same one.

In this embodiment, the gain control information is indicated in the property and sent to the processing device 32. Therefore, the processing device 32 obtains the information required for automatic adjustment, and the gain control based on automatic adjustment becomes simpler and more efficient; moreover, the control device 31 can control detailed parameters of the automatic gain control exercised by the processing device 32.

Those skilled in the art can understand that all or part of the steps in the above embodiments can be implemented by program-instructing hardware, and the program may be stored in a computer readable storage medium. When the program is executed, the steps in the above method embodiments are performed. The storage medium mentioned above may be all kinds of medium that can store program codes, including but not limited to, Read-Only Memory (ROM), Random Access Memory (RAM), Disc or Compact Disc (CD).

It should be noted that, the above exemplary embodiments are only intended to illustrate, but are not intended to limit, the technical solution according to embodiments of the present invention. Though embodiments of the present invention are described with reference to the above exemplary embodiments, those skilled in the art shall understand that: modifications may be made to technical solutions recorded in the exemplary embodiments of the present invention, and variations or replacement can be made to some of the technical features; while those modifications, variations or replacement will not make the essence of the corresponding technical solutions depart from the spirits or scope of technical solutions according to embodiments of the invention shall.

## Claims

1. A method for exercising gain control, comprising:
obtaining control information related to automatic gain control; and
exercising automatic gain control according to the control information.

2. The method for exercising gain control according to claim 1, wherein:
the control information comprises at least one of: start level, target level, and silence threshold.

3. The method for exercising gain control according to claim 2, wherein:
the control information is specific to an incoming direction and/or an outgoing direction respectively.

4. The method for exercising gain control according to claim 1, wherein:
an automatic gain control indication is received when the control information related to automatic gain control is obtained.

5. The method for exercising gain control according to claim 1, wherein:
the exercising automatic gain control is: sending a processing error response, if no automatic gain control indication is received when the control information related to automatic gain control is obtained.

6. The method for exercising gain control according to any one of claims 2-5, wherein:
a property of a gateway control protocol indicates the control information or each item of the control information.

7. The method for exercising gain control according to any one of claims 1-5, wherein:
the control information is sent by a Media Gateway Controller (MGC) to a Media Gateway (MG), or is preset on the MG; or
the control information is sent by a media resource control device to a media resource processing device, or is preset on the media resource processing device; or
the control information is sent by a media control function device to a media delivery function device, or is preset on the media delivery function device.

8. A processing device, comprising:
an obtaining unit, configured to obtain control information related to automatic gain control; and
a processing unit, configured to exercise automatic gain control according to the control information.

9. The processing device according to claim 8, wherein the obtaining unit comprises:
a receiving unit, configured to receive, from the control device, the control information related to automatic gain control; or
a setting unit, configured to preset the control information related to the automatic gain control.

10. The processing device according to claim 9, further comprising:
a sending unit, configured to send a processing error response, if the receiving unit receives no automatic gain control indication when receiving the control information related to the automatic gain control.

11. The processing device according to claim 9, wherein:
the control information comprises at least one of: start level, target level, and silence threshold.

12. The processing device according to claim 11, wherein:
the control information is specific to an incoming direction and/or an outgoing direction respectively.

13. The processing device according to claim 11 or 12, wherein:
a property of a gateway control protocol indicates the control information or each item of the control information.

14. The processing device according to any one of claims 8-12, wherein:
the processing device is a Media Gateway (MG), or a media resource processing device, or a media delivery function device.

15. A system for exercising gain control, comprising:
a control device, configured to send control information related to automatic gain control to a processing device; and
the processing device, configured to receive, from the control device, the control information related to the automatic gain control, and exercise automatic gain control according to the control information.

16. The system for exercising gain control according to claim 15, wherein:
the control device is further configured to receive a processing error response returned, if the control device sends no automatic gain control indication when sending the control information related to the automatic gain control.

17. The system for exercising gain control according to claim 15 or 16, wherein:
the control information comprises at least one of: start level, target level, and silence threshold.

18. The system for exercising gain control according to claim 15 or 16, wherein:
the control information is specific to an incoming direction and/or an outgoing direction respectively.

19. The system for exercising gain control according to claim 17, wherein:
a property of a gateway control protocol indicates the control information or each item of the control information.

20. The system for exercising gain control according to claim 15 or 16, wherein:
the control device is a Media Gateway Controller (MGC), or a media resource control device, or a media control function device; and the processing device is a Media Gateway (MG), or a media resource processing device, or a media delivery function device.
